# EUROPÄISCHE PATENTSCHRIFT

(11) **EP 0 304 799 B1**
(45) Veröffentlichungstag und Bekanntmachung des Hinweises auf die Patenterteilung: **20.12.1995**
(21) Anmeldenummer: 88113413.4
(22) Anmeldetag: 18.08.1988
(51) Int. Cl.: H03M 5/12

(54) **Einrichtung zum Demodulieren eines Biphasesignales**
Apparatus for demodulating a biphase signal
Dispositif pour démoduler un signal biphasé

(30) Priorität: 27.08.1987 DE 3728655
(43) Veröffentlichungstag der Anmeldung: 01.03.1989
(73) Patentinhaber: Deutsche Thomson-Brandt GmbH, 78003 Villingen-Schwenningen (DE)
(72) Erfinder: Füldner, Friedrich, Dipl.-Ing., D-7730 VS-Villingen (DE)

(56) Entgegenhaltungen:
- EP-A- 0 062 945
- EP-A- 0 186 462
- FR-A- 2 345 009
- US-A- 4 040 100
- US-A- 4 344 039
- US-A- 4 626 670
- IEEE TRANSACTIONS ON CONSUMER ELECTRONICS, Bd. CE-33, Nr. 3, August 1987, New York,US;Seiten 383 - 393; R. OGAWA et al.: "Development or Radio Data System Decoder IC's"

## Beschreibung

Die Erfindung betrifft eine Einrichtung zum Demodulieren eines binär codierten phasenmodulierten Signales (Biphasesignal).

Eine Einrichtung der eingangs genannten Art ist aus den Specificationen der European Broadcasting Union, Tech. 3244-E, Brüssel, März 1984, bekannt. Bei der bekannten Schaltung ist es von Nachteil, daß zur Taktrückgewinnung der Bitrate des RDS-Biphasesignals von 1187,5 Hz eine sehr exakt laufende Anordnung erforderlich ist.

Der Erfindung liegt die Aufgabe zugrunde, eine Einrichtung zum Demodulieren eines Biphasesignals nach dem Oberbegriff des Anspruchs 1 anzugeben, durch die auf relativ einfache Weise die ursprünglichen Daten mit hinreichender Sicherheit zurückgewonnen werden können.

Diese Aufgabe wird durch die im Anspruch 1 angegebenen Merkmale gelöst.

Weitere Vorteile, Merkmale und Einzelheiten der Erfindung werden nachfolgend anhand der Zeichnung an zwei Ausführungsbeispielen erläutert. Dabei zeigen
- Fig. 1: Ein Blockschaltbild einer erfindungsgemäßen Einrichtung zum Demodulieren eines Biphasesignals,
- Fig. 2: Ein Impulsdiagramm zur Darstellung der Signalverläufe an verschiedenen Stellen der in Fig. 1 abgebildeten Schaltung und
- Fig. 3:: Ein Flußdiagramm zur Erläuterung des der erfindungsgemäßen Einrichtung zugrundeliegenden Verfahrens.

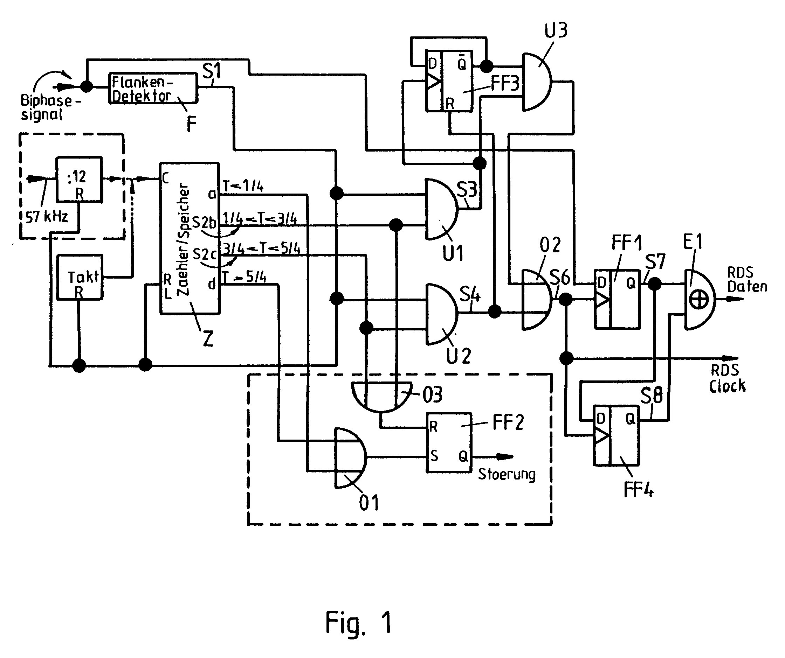

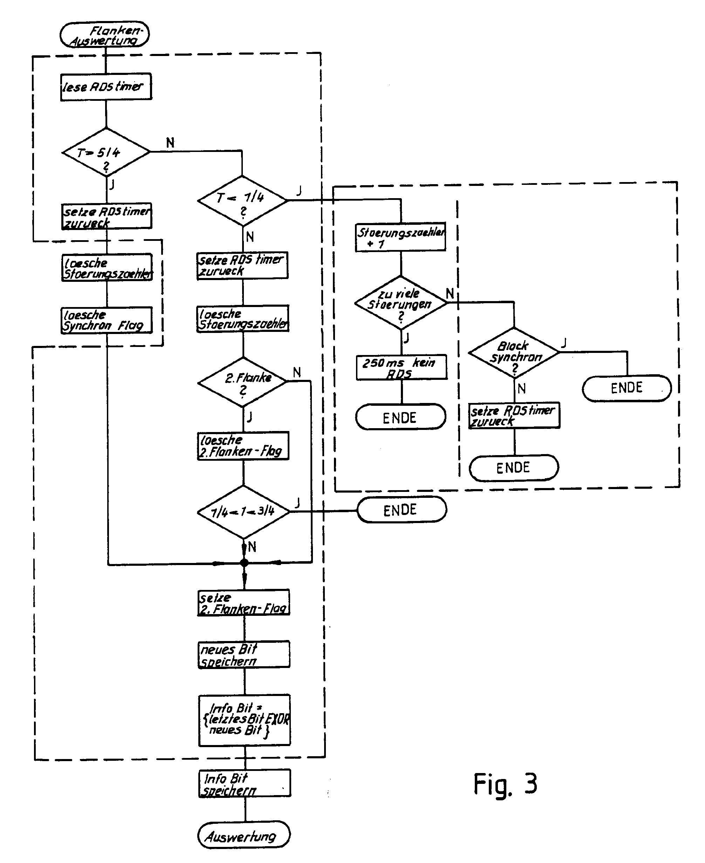

Sowohl die in Fig. 1 dargestellte Schaltung als auch das in Fig. 3 an einem Flußdiagramm erläuterte Verfahren zum Demodulieren eines Biphasesignals sind vorgesehen für Rundfunkgeräte, die zur Ausgabe von Daten gemäß dem oben zitierten RDS (Radio-Daten-System)-Standard geeignet sind.

Senderseitig wird dabei das RDS-Signal über einen Differential-Encoder mit einer Bitrate von 1187,5 Hz einem Biphasesymbolgenerator zugeführt und auf einem 57 kHz-Hilfsträger phasenmoduliert einem FM-Multiplexsignal mit unterdrücktem Hilfsträger aufaddiert.

Auf der Empfängerseite wird aus dem FM-Multiplexsignal das 57 kHz-Signal herausgefiltert und einem Synchrondemodulator zugeführt, wonach es als Biphasesignal vorliegt.

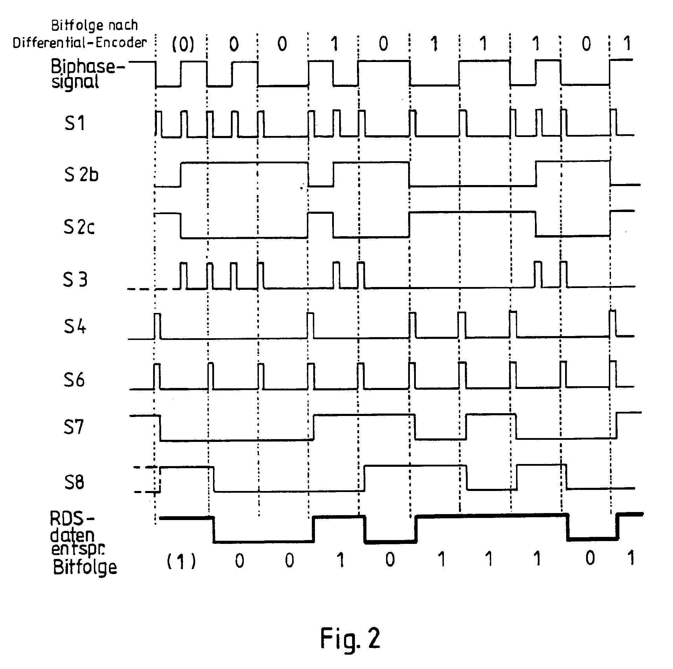

In Fig. 1 ist ein einlaufendes, auf Digitalpegel umgeformtes Biphasesignal dargestellt, das einem Flankendetektor F zugeführt wird. Am Ausgang des Flankendetektors F steht ein Signal S1 an, das - wie Fig. 2 entnehmbar - kurze Impulse jeweils zu dem Zeitpunkten aufweist, zu denen das ebenfalls in Fig. 2 dargestellte Biphasesignal einen Pegelsprung aufweist. In Fig. 2 ist zur besseren Erläuterung über dem Biphasesignal die diesem zugeordnete ursprüngliche Bitfolge notiert. Vom Ausgang des Flankenkdetektors F wird das Signal S1 dem Reset-Eingang R eines kombinierten Zählers und Speichers Z und dem Reset-Eingang eines Taktgenerators, der entweder als freilaufender Taktgenerator oder, wie im Bild durch gestrichelte Linien eingerahmt dargestellt, mittels eines Teilers (Division durch 12) abgeleitet aus dem 57 kHz-Hilfsträger realisiert ist, wobei der Ausgang des Teilers -oder stattdessen der Ausgang des freilaufenden Taktgenerators - auf einen Eingang C des Zählers Z geführt ist.

Das Ausgangssignal des Flankendetektors F wird außerdem noch je einem Eingang zweier UND-Gatter U1 bzw. U2 zugeführt. Der Zähler/Speicher Z weist vier Ausgänge a - d auf, an denen -wie in der Zeichnung symbolisch angegeben und für die Ausgänge b und c in Fig. 2 durch die Signalverläufe S2b bzw. S2c dargestellt - bei unterschiedlichen Voraussetzungen Signale anstehen. Am Ausgang a erscheint ein High-Signal, wenn eine Zeitdauer T zwischen zwei Flanken des Biphasesignals kleiner als 1/4 einer Bitrate auftritt. Am Ausgang d erscheint ein High-Signal, wenn die Zeitdauer T größer als 5/4 einer Bitrate festgestellt wird. Diese beiden Ausgänge werden auf auf ein ODER-Gatter 01 geführt, dessen Ausgang dem S-Eingang eines RS-Flip-Flops FF2 zugeführt ist. Am Q-Ausgang des Flip-Flops FF2 liegt dann ein mit "Störung" bezeichnetes Signal vor.

Der Ausgang b des Zählers/Speichers Z führt ein High-Signal, wenn die ermittelte Zeitdauer T zwischen 1/4 und 3/4 der Bitrate liegt. Dieses Signal wird auf einen zweiten Eingang des UND-Gatters U1 gegeben, an dessen Ausgang ein Signal der Form S3, vergleiche Fig. 2, erscheint und auf den Takteingang eines D-Flip-Flops FF3 sowie einen Eingang eines UND-Gatters U3 gelangt. Der Q-Ausgang des Flip Flops FF3 wird auf dessen D-Eingang sowie auf einen zweiten Eingang des UND-Gatters U3 geführt, dessen Ausgang ein Signal der Form S5 aufweist und einem ODER-Gatter 02 zugeführt ist.

Der Ausgang c des Zählers/Speichers Z führt ein High-Signal, wenn die Zeitdauer T zwischen 3/4 und 5/4 der Bitrate liegt, der zugehörige Signalverlauf S2c ist in Fig. 2 dargestellt. Dieses Signal wird einem zweiten Eingang des UND-Gatters U2 zugeführt, an dessen Ausgang ein Signal der Form S4, vergl. Fig. 2, an den Reset-Eingang R sowie an einen zweiten Eingang des ODER-Gatters 02 angelegt. Am Ausgang dieses ODER-Gatters 02 wird ein Signal der Form S6 ausgegeben, das auf den Takteingang des Flip-Flops FF1 sowie eines weiteren Flip-Flops FF4 gegeben wird und zugleich auch als RDS-Clock-Ausgang der Schaltungsanordnung dient. Der Q-Ausgang des Flip-Flops FF1 führt ein Signal der Form S7 und wird an den Eingang eines EXOR-Gatters E1 sowie an den D-Eingang des Flip-Flops FF4 gegeben, dessen Q-Ausgang ein Signal der Form S8 aufweist und an den zweiten Eingang des EXOR-Gatters E1 geführt ist, an dessen Ausgang die RDS-Daten ausgegeben werden.

Die Ausgänge b und c des Zählers/Speichers Z sind noch an ein ODER-Gatter 03 geführt, dessen Ausgang mit dem Reset-Eingang des Flip-Flops FF2 verbunden ist, sodaß ein an diesem Flip-Flop FF2 ausgegebenes Störungssignal erlischt, sobald einer der Ausgänge b oder c wieder "normale Verhältnisse" signalisiert.

Wird am Ausgang b ein High-Signal ausgegeben, so werden die Zustände des an der Schaltung ankommenden Biphasesignals mit der halben Taktrate übernommen, da die Abtastimpulse mit der doppelten Frequenz der Bitrate kommen. Dies wird mit dem D-Flip-Flop FF3 erreicht, das als Teiler geschaltet ist. Wird am Ausgang c ein High-Signal ausgegeben, so wird das als Teiler arbeitende Flip-Flop FF3 synchronisiert und so gewährleistet, daß beim nächsten Auftreten eines High-Signals am Ausgang b die "richtige" Flanke des Biphasesignals übernommen wird.

Die beiden D-Flip-Flops FF1 und FF4 und das EXOR-Gatter E1 bilden zusammen einen Differenz-Decoder. Die an dem Ausgang des EXOR-Gatters E1 ausgegebenen RDS-Daten sind in Fig. 2 durch Fettdruck hervorgehoben dargestellt, zur Verdeutlichung ist darunter die entsprechende Bitfolge notiert. Man sieht, daß diese Bitfolge der ursprünglichen Bitfolge entspricht.

Das in Fig. 3 dargestellte Verfahren zur Demodulation eines Biphasesignals bezieht sich im wesentlichen auf die zuvor ausführlich erläuterte Schaltung gemäß Fig. 1, wobei im wesentlichen der Startpunkt "Flanken-Auswertung" der Stelle in Fig. 1 entspricht, an der das Biphase-Signal einläuft, und der in dem größeren der beiden durch gestrichelte Linien eingerahmten Teil des Ablaufdiagramms befindliche letzte Schritt "Info Bit = (letztes Bit) EXOR (neues Bit)" der Stelle in Fig. 1 entspricht, an der am Ausgang des EXOR-Gatters E1 die RDS-Daten ausgegeben werden.

## Patentansprüche

1. Einrichtung zum Demodulieren eines binär codierten phasenmodulierten Signales (Biphase-Signal) unter Verwendung eines Differential-Decodierers mit zwei Flipflops und einem EXOR-Gatter (E1), wobei
- dem Dateneingang des ersten Flipflops (FF1) das binär codierte phasenmodulierte Signal zugeführt wird;
- das Ausgangssignal des ersten Flipflops einem ersten Eingang des EXOR-Gatters und dem Dateneingang des zweiten Flipflops (FF2) zugeführt wird;
- das Ausgangssignal des zweiten Flipflops dem zweiten Eingang des EXOR-Gatters zugeführt wird;
- ein weiteres Eingangssignal den Clock-Eingängen der beiden Flipflops zugeführt wird,
**gekennzeichnet durch:**
- das binär codierte phasenmodulierte Signal wird ebenfalls einem Flankendetektor (F) zugeführt, dessen Ausgangssignal (S1) einem ersten Eingang eines ersten UND-Gatters (U1), dem ersten Eingang eines zweiten UND-Gatters (U2), dem Reset-Eingang einer Abfrageschaltung (Z) und dem Reset-Eingang (R) eines Taktgenerators zugeführt wird;
- das Ausgangssignal des Taktgenerators wird dem Clock-Eingang der Abfrageschaltung zugeführt;
- ein erster Ausgang (b) der Abfrageschaltung wird dem zweiten Eingang des ersten UND-Gatters zugeführt;
- ein zweiter Ausgang (c) der Abfrageschaltung wird dem zweiten Eingang des zweiten UND-Gatters zugeführt;
- das Ausgangssignal des ersten UND-Gatters wird dem Clock-Eingang eines dritten Flipflops (FF3) und dem ersten Eingang eines dritten UND-Gatters (U3) zugeführt;
- das invertierte Ausgangssignal des dritten Flipflops wird dem zweiten Eingang des dritten UND-Gatters und dem Dateneingang dieses Flipflops zugeführt;
- das Ausgangssignal des dritten UND-Gatters wird einem ersten Eingang eines ODER-Gatters (02) zugeführt;
- das Ausgangssignal des zweiten UND-Gatters wird dem zweiten Eingang des ODER-Gatters und dem Rücksetzeingang des dritten Flipflops zugeführt;
- das Ausgangssignal des ODER-Gatters bildet das weitere Eingangssignal,
wobei der Taktgenerator eine Frequenz B abgibt, die ungefähr der Bitrate des binär codierten phasenmodulierten Signals entspricht und wobei die Zeitdauer T zwischen zwei Pegelsprüngen des binär codierten phasenmodulierten Signals in der Abfrageschaltung (Z) mit der Takt-Dauer 1/B verglichen wird und das Ausgangssignal an deren erstem Ausgang (b) logisch 'High' ist, wenn
- a) (1/4)*(1/B) < T < (3/4)*(1/B)
und das Ausgangssignal an deren zweitem Ausgang (c) logisch 'High' ist, wenn
- b) (3/4)*(1/B) < T < (5/4)*(1/B);
sodaß die Einrichtung nur dann den logischen Wert des binär codierten phasenmodulierten Signales ermittelt, wenn die Bedingungen a) oder b) erfüllt wurden.

2. Einrichtung nach Anspruch 1, **dadurch gekennzeichnet**, daß der Taktgenerator seine Ausgangsfrequenz aus dem 57kHz-Hilfsträger eines RDS-Signals ableitet.

3. Einrichtung nach Anspruch 1, **dadurch gekennzeichnet**, daß der Taktgenerator mit etwa der vierfachen Frequenz der Bitrate des binär codierten phasenmodulierten Signales läuft.

4. Einrichtung nach einem der Ansprüche 1 bis 3, **dadurch gekennzeichnet**, daß die Abfrageschaltung (Z) weitere Signale abgibt, die in den Fällen T < (1/4)*(1/B) oder T > (5/4)*(1/B) zur Kennzeichnung einer Störung dienen.

5. Verwendung der Einrichtung nach einem oder mehreren der Ansprüche 1 bis 4 zur Decodierung eines RDS-Signals.

## Claims

1. Apparatus for demodulating a binary coded, phase modulated signal (biphase signal) using a differential decoder having two flip flops and an EXOR gate (E1) wherein
- the binary coded, phase modulated signal is supplied to the data input of the first flip flop (FF1);
- the output signal of the first flip flop is supplied to a first input of the EXOR gate and to the data input of the second flip flop (FF2);
- the output signal of the second flip flop is supplied to the second input of the EXOR gate;
- a further input signal is supplied to the clock inputs of the two flip flops,
characterised in that:
- the binary coded, phase modulated signal is also supplied to an edge detector (F) whose output signal (S1) is supplied to a first input of a first AND gate (U1), to the first input of a second AND gate (U2), to the reset input of an interrogation circuit (Z) and to the reset input (R) of a clock pulse generator;
- the output signal of the clock pulse generator is supplied to the clock input of the interrogation circuit;
- a first output (b) of the interrogation circuit is supplied to the second input of the first AND gate;
- a second output (c) of the interrogation circuit is supplied to the second input of the second AND gate;
- the output signal of the first AND gate is supplied to the clock input of a third flip flop (FF3) and to the first input of a third AND gate (U3);
the inverted output signal of the third flip flop is supplied to the second input of the third AND gate and to the data input of this flip flop;
- the output signal of the third AND gate is supplied to a first input of an OR gate (02);
- the output signal of the second AND gate is supplied to the second input of the OR gate and to the reset input of the third flip flop;
- the output signal of the OR gate forms the further input signal,
wherein the clock pulse generator emits a frequency B which approximately corresponds to the bit rate of the binary coded, phase modulated signal and wherein the time period T between two jumps in the level of the binary coded, phase modulated signal is compared with the clock period 1/B in the interrogation circuit (Z) and the output signal at its first output (b) is a logical "High" when
- a) (1/4) * (1/B) < T < (3/4) * (1/B)
and that the output signal at its second output (c) is a logical "High" when
- b) (3/4) * (1/B) < T < (5/4) * (1/B);
so that the apparatus only detects the logical value of the binary coded, phase modulated signal when the conditions a) or b) are fulfilled.

2. Apparatus in accordance with Claim 1, characterised in that, the clock pulse generator derives its output frequency from the 57 kHz sub carrier of an RDS signal.

3. Apparatus in accordance with Claim 1, characterised in that, the clock generator runs at approximately four times the frequency of the bit rate of the binary coded, phase modulated signal.

4. Apparatus in accordance with any of the Claims 1 to 3, characterised in that, the interrogation circuit (Z) emits further signals which serve to indicate a disturbance in the cases T < (1/4) * (1/B) or T > (5/4) * (1/B).

5. Use of the apparatus in accordance with any one or more of the Claims 1 to 4 for decoding an RDS signal.

## Revendications

1. Dispositif destiné à la démodulation d'un signal codé en binaire à modulation de phase (signal biphasé), impliquant l'utilisation d'un décodeur différentiel avec deux bascules et une porte OU exclusif (E1),
- le signal codé en binaire à modulation de phase étant amené vers l'entrée de données de la première bascule (FF1) ;
- le signal de sortie de la première bascule étant amené vers une première entrée de la porte OU exclusif et vers l'entrée de données de la deuxième bascule (FF2) ;
- le signal de sortie de la deuxième bascule étant amené vers la deuxième entrée de la porte OU exclusif ;
- un autre signal d'entrée étant amené vers les entrées d'horloge des deux bascules,
**caractérisé en ce que**
- un signe codé en binaire à modulation de phase est également amené vers un détecteur de flancs (F) dont le signal de sortie (S1) est amené vers une première entrée d'une première porte ET (U1), vers une première entrée d'une deuxième porte ET (U2), vers l'entrée de réinitialisation d'un circuit de balayage (z) et l'entrée de réinitialisation (R) d'un générateur d'impulsions ;
- le signal de sortie du générateur d'impulsions est amené vers l'entrée d'horloge du circuit de balayage ;
- une première sortie (b) du circuit de balayage est amenée vers la deuxième entrée de la première porte ET ;
- une deuxième sortie (c) du circuit de balayage est amenée vers la deuxième entrée de la deuxième porte ET ;
- le signal de sortie de la première porte ET est amené vers l'entrée d'horloge d'une troisième bascule (FF3) ainsi que vers la première entrée d'une troisième porte ET (U3) ;
- le signal de sortie inversé de la troisième bascule est amené vers la deuxième entrée de la troisième porte ET et vers l'entrée de données de cette bascule ;
- le signal de sortie de la troisième porte ET est amené vers une première entrée de la porte OU (02) ;
- le signal de sortie de la deuxième porte ET est amené vers la deuxième entrée de la porte OU et vers l'entrée de réinitialisation de la troisième bascule ;
- le signal de sortie de la porte OU constitue l'autre signal d'entrée, le générateur d'impulsions émettant une fréquence B qui correspond approximativement au débit binaire du signal codé en binaire à modulation de phase, le temps T entre les deux sauts de niveau du signal codé en binaire à modulation de phase dans le circuit de balayage (Z) étant comparé à la durée de l'impulsion 1/B et le signal de sa première sortie (B) étant logiquement "haut", lorsque
- a) (1/4)*(1/B) < T < (3/4)*(1/B)
et que le signal de sa deuxième sortie (c) étant logiquement "haut", lorsque
- b) (3/4) * (1/B) < T < (5/4) * (1/B),
de sorte que le dispositif ne détermine la valeur logique du signal codé en binaire à modulation de phase que lorsque les conditions a) ou b) ont été remplies.

2. Dispositif selon la revendication 1, caractérisé en ce que le générateur d'impulsions déduit sa fréquence de sortie de la sous-porteuse de 57 kHz d'un signal SDR.

3. Dispositif selon la revendication 1, caractérisé en ce que le générateur d'impulsions fonctionne approximativement à la quadruple fréquence du débit binaire du signal codé en binaire à modulation de phase.

4. Dispositif selon l'une des revendications 1 à 3, caractérisé en ce que le circuit de balayage (z) émet d'autres signaux qui permettent dans les cas T < (1/4) * (1/B) ou T > (5/4) * (1/B) de repérer un défaut.

5. Utilisation du dispositif selon une ou plusieurs des revendications 1 à 4 pour le décodage d'un signal SDR.
